# EUROPÄISCHE PATENTSCHRIFT

(11) **EP 0 258 842 B1**
(45) Veröffentlichungstag und Bekanntmachung des Hinweises auf die Patenterteilung: **30.11.1994**
(21) Anmeldenummer: 87112561.3
(22) Anmeldetag: 28.08.1987
(51) Int. Cl.: H03M 1/06, H03M 1/38

(54) **Analog-Digital-Umsetzer mit Kapazitätsnetzwerk**
Analog-to-digital converter with a capacitiv network
Convertisseur analogique-numérique à réseau capacitif

(30) Priorität: 01.09.1986 DE 3629737
(43) Veröffentlichungstag der Anmeldung: 09.03.1988
(73) Patentinhaber: SIEMENS AKTIENGESELLSCHAFT, 80333 München (DE)
(72) Erfinder: Draxelmayr, Dieter, Dipl.-Ing., A-9500 Villach (AT); Schrittesser, Gerold, Dipl.-Ing., A-9500 Villach (AT)

(56) Entgegenhaltungen:
- EP-A- 0 078 608
- US-A- 4 195 282
- ELECTRONIC ENGINEERING, Band 51, Nr. 632, Dezember 1979, Seiten 82- 87, London, GB; M.J. WALSH: "A one-chip A/D converter in MOS"
- ELECTRONICS LETTERS, Band 22, Nr. 1, 2. Januar 1986, Seiten 43-44, Stevenage, Herts, GB; K. NAGARAJ et al.: "High-CMRR stray-insensitive switched-capacitor differential input stage for A/D convertors"
- IEEE JOURNAL OF SOLID-STATE CIRCUITS, Band SC-21, Nr. 4, August 1986, Seiten 544-554, IEEE, New York, US; C.C. SHIH et al.: "Reference refreshing cyclic analog-to-digital and digital-to-analog converters"
- IEEE JOURNAL OF SOLID-STATE CIRCUITS, Band SC-14, Nr. 6, Dezember 1979, Seiten 926-932, New York, US; A.G.F. DINGWALL: "Monolithic expandable 6 Bit 20 MHz CMOS/SOS A/D converter"

## Beschreibung

Die Erfindung betrifft einen Analog-Digital Umsetzer nach dem Oberbegriff des Patentanspruchs 1 bzw. des Patentanspruchs 2.

Ein derartiger Analog-Digital-Umsetzer nach dem Prinzip der Ladungsverteilung mit einem gewichteten Kapazitätsnetzwerk ist beispielsweise aus dem Buch "Elektronische Analog-Digital-Umsetzer" von D. Seitzer, Springer-Verlag, Berlin, Heidelberg, New York, 1977, S. 55 ff bekannt.

In der vorgenannten Veröffentlichung ist ausgeführt, daß die Umwandlung eines Analogwertes in einer Folge von drei Operationen erfolgt. Im Abtastmodus werden die Kapazitäten mit einer der zu messenden analogen Spannung proportionalen Ladung aufgeladen, im Haltemodus werden die Schalter so umgelegt, daß am Komparatoreingang betragsmäßig das zu messende Analogpotential liegt und im Umverteilungsmodus werden die Kapazitäten sukzessive mit einem Referenzpotential verbunden, so daß am Komparatorausgang schrittweise die Bits des der zu wandelnden Analog-Spannung zugeordneten Digitalwortes zur Verfügung stehen.

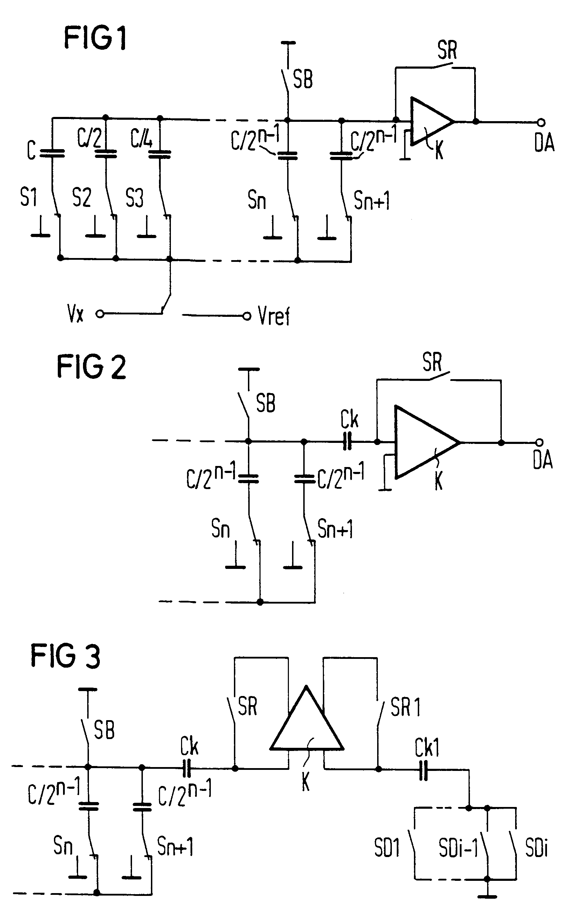

Ein Ausführungsbeispiel einer derartigen Schaltungsanordnung ist in Fig. 1 dargestellt. Die Kapazitäten sind durch ihre duale Wichtung mit C, C/2, ..., C/2ⁿ⁻¹ bezeichnet. Der Gesamtwert der Kapazitäten beträgt 2C, ihre Anzahl eine mehr als Dualstellen gebildet werden sollen, da der kleinste Kapazitätswert doppelt auftritt. Die Kapazitäten sind mit einem Anschluß jeweils an einen Eingang des Komparators K und über den Schalter SB mit dem Bezugspotential verbunden. Der jeweils andere Anschluß der Kapazitäten ist über Schalter S1, S2 bis Sn und Sn + 1 jeweils entweder mit dem Bezugspotential oder aber mit einer Sammelschiene verbunden, wobei die Sammelschiene über einen zusätzlichen Schalter entweder auf dem zu messenden Analogpotential Vx oder einem Referenzpotential Vref liegt. Im Ausführungsbeispiel gemäß Fig. 1 ist der Komparator K mit einem über den Schalter SR zuschaltbaren Rückkopplungskreis versehen, er kann aber auch anders beschaltet sein. Der Ausgang des Komparators bildet den Digitalausgang DA des Umsetzers.

Gemäß Fig. 1 ist das gesamte Kapazitätsnetz direkt mit dem Eingang des Komparators verbunden. Bei der Offset-Kompensation des Komparators muß deshalb zunächst das gesamte Kapazitätsnetz geladen werden, wodurch der Analog-Digital-Umsetzer vergleichsweise langsam arbeitet. Sur Implementierung eines differentiellen Analog-Digital-Umsetzers muß aus Symmetriegründen am zweiten Eingang des Komparators ebenfalls ein Kapazitätsnetzwerk angeschlossen werden.

Aus "Electronic Engineering", Bd. 51, Nr. 632, Dez. 1979, Seiten 82-87, London; M. J. Walsh: "A one-chip A/D converter in MOS" ist eine ähnliche Anordnung bekannt. Beschrieben ist auch die Offset-Kompensation mit Hilfe eines einem Inventer vorgeschalteten Kondensators, der gleichzeitig Sample-and-Hold-Element eines A/D-Wandlers mit Widerstandsnetzwerk ist. Ganz allgemein wird auf die Möglichkeit einer Offset-Kompensation bei A/D-Wandlern mit Kapazitätsnetzwerk hingewiesen.
Ähnliche Schaltungen zur Offset-Kompensation mit Hilfe eines Koppelkondensators sind aus IEEE Journal of Solid-State-Circuits, Band SC-21, Nr. 4, Aug. 1986, S. 544-554, C.C. Smith et.al.: "Reference refreshing cyclic analog-to-digital and digital-to-analog converters", insbesondere Figur 6(a) und IEEE Journal of Solid-State Circuits, Band SC-14, Nr. 6, Dez. 1979, S. 926-932; A.G.F. Dingwall "Monolithic expandable 6 Bit 20 MHz CMOS/SOS A/D converter" bekannt.
Keine der Druckschriften zeigt eine differentielle Struktur für kapazitive A/D-Wandler.

Der Erfindung liegt die Aufgabe zugrunde, einen Analog-Digital-Umsetzer nach dem Prinzip der Ladungsverteilung mit einem gewichteten Kapazitätsnetzwerk anzugeben, dessen Zeitverhalten und parasitäre Eigenschaften verbessert sind.

Diese Aufgabe wird durch die Merkmale des Patentansprüche 1 oder 2 gelöst.

Weiterbildungen des Erfindungsgedankens sind im Unteranspruch gekennzeichnet.

Die Erfindung wird im folgenden anhand von in den Figuren der Zeichnung dargestellten Ausführungsbeispielen näher er läutert. Dabei sind gleiche Elemente mit gleichen Bezugszeichen versehen. Es zeigt:
- Fig. 1: den bereits beschriebenen bekannten Analog-Digital-Umsetzer,
- Fig. 2: eine relevante Teilschaltung eines erfindungsgemäßen Analog-Digital-Umsetzers und
- Fig. 3: eine Teilschaltung eines Ausführungsbeispiels für einen erfindungsgemäßen differentiellen Analog-Digital-Umsetzer.

Fig. 2 unterscheidet sich von der entsprechenden Teilschaltung der Fig. 1 darin, daß dem Komparator K erfindungsgemäß eingangsseitig ein Koppelkondensator Ck vorgeschaltet ist. Der Koppelkondensator ermöglicht einerseits eine Verbesserung des Zeitverhaltens des erfindungsgemäßen Analog-Digital-Umsetzers, da bei der Offset-Kompensation des Komparators nicht mehr das gesamte Kapazitätsnetz geladen werden muß, sondern nur noch der Koppelkondensator Ck in Serie mit dem Kapazitätsnetz. Bei der Serienschaltung von Kapazitäten erhält man bekanntlich eine Ersatzkapazität, die kleiner ist als die kleinste Einzelkapazität, wobei im Ausführungsbeispiel das Kapazitätsnetzwerk jeweils als eine Kapazität, z.B. als Gesamtkapazität 2C betrachtet werden muß.

Andererseits ermöglicht der Koppelkondensator CK eine einfache Implementierbarkeit einer differentiellen Struktur, wie sie in einer Teilschaltung in dem Ausführungsbeispiel gemäß Fig. 3 dargestellt ist. An einem Eingang ist dabei der Komparator K gemäß der Teilschaltung nach Fig. 2 beschaltet. Dem anderen Eingang des Komparators K ist erfindungsgemäß ebenfalls ein weiterer Koppelkondensator Ck1 vorgeschaltet, der an seinem freien Einang über eine Simulations-Schalteranordnung mit einem gemeinsamen Potential, vorzugsweise dem Bezugspotential des Analog-Digital-Umsetzers verbunden ist. Diese Simulations-Schalteranordnung, die die Schalter SD1 bis SDi enthält, dient zur Nachbildung des komplexen Schaltungszweiges mit dem Kapazitätsnetzwerk am anderen Eingang des Komparators. So lassen sich beispielsweise mit Hilfe der Simulations-Schalteranordnung und der weiteren Koppelkapazität Ck1 der gesamte Schalterwiderstand oder aber einzelne Schaltvorgänge des Schaltungszweiges mit dem Kapazitätsnetzwerk am zweiten Eingang des Komparators nachbilden. Ohne diese weitere Koppelkapazität Ck1 müßte aus Symmetriegründen der zweite Eingang des Komparators ebenfalls mit einem Kapazitätsnetz beschaltet werden. Für die dem zweiten Eingang des Komparators seriell vorgeschaltete Koppelkapazität Ck1 genügt demgegenüber eine wesentlich kleinere Kapazität, so daß der Aufwand zur Implementierung dieser Differenzstruktur wesentlich geringer wird.

## Patentansprüche

1. Analog-Digital-Umsetzer nach dem Prinzip der Ladungsverteilung mit einem Kapazitätsnetzwerk (C bis C/2ⁿ⁻¹), bei dem die Kapazitätswerte dual gewichtet sind und der kleinste Kapazitätswert (C/2ⁿ⁻¹) doppelt ausgeführt ist, bei dem die Kapazitäten (C bis C/2ⁿ⁻¹) jeweils mit einem Anschluß mit einem ersten Eingang eines Komparators (K) verbunden sind und über einen Bezugsschalter (SB) an einem Bezugspotential (Masse) liegen und bei dem die Kapazitäten (C bis C/2ⁿ⁻¹) mit ihrem jeweils anderen Anschluß über jeweils einen weiteren Schalter (S1 bis Sn+1) mit einem Eingangs-Analogpotential (Vx), einem Referenz- (Vref) oder einem Bezugspotential (Masse) verbunden sind,
**dadurch** **gekennzeichnet,**
daß der jeweils Anschluß der Kapazitäten einerseits und der erste Eingang des Komparators (K) andererseits jeweils unlösbar an die Anschlüsse eines Koppelkondensators (Ck) angeschlossen sind und
daß an einen zweiten Eingang des Komparators (K) ein weiterer, mit einem gemeisamen Potential (Masse) verbundener Koppelkondensator (Ck1) fest angeschlossen ist, dessen Wert im wesentlichen durch den Kapazitätswert der Serienschaltung des Koppelkondensators (Ck) und des Kapazitätsnetzwerks (C bis C/2ⁿ⁻¹) bestimmt ist.

2. Analog-Digital-Umsetzer nach dem Prinzip der Ladungsverteilung mit einem Kapazitätsnetzwerk (C bis C/2ⁿ⁻¹), bei dem die Kapazitätswerte dual gewichtet sind und der kleinste Kapazitätswert (C/2ⁿ⁻¹) doppelt ausgeführt ist, bei dem die Kapazitäten (C bis C/2ⁿ⁻¹) jeweils mit einem Anschluß mit einem ersten Eingang eines Komparators (K) verbunden sind und über einen Bezugsschalter (SB) an einem Bezugspotential Masse liegen und bei dem die Kapazitäten (C bis C/²ⁿ⁻¹) mit ihrem jeweils anderen Anschluß über jeweils einen weiteren Schalter (S1 bis Sn+1) mit einem Eingangs-Analogpotential (Vx), einem Referenz-(Vref) oder einem Bezugspotential (Masse) verbunden sind,
**dadurch** **gekennzeichnet**,
daß dem ersten Eingang des Komparators (K) ein Koppelkondensator (CK) und einem zweiten Eingang des Komparators (K) ein weiterer, über eine Simulations-Schalteranordnung (SD1 bis SDi) mit dem Bezugspotential (Masse) verbundener Koppelkondensator (Ck1) vorgeschaltet sind.

3. Analog-Digital-Umsetzer nach Anspruch 2,
**dadurch** **gekennzeichnet**,
daß die Simulations-Schalteranordnung (SD1 bis SDi) ausgelegt ist, um den gesamten Schalterwiderstand oder Schaltvorgänge des Umsetzerweiges mit dem Kapazitätsnetzwerk (C bis C/²ⁿ⁻¹) nachbilden zu können.

## Claims

1. Analog/digital converter operating on the principle of charge distribution with a capacitor network (C to C/2ⁿ⁻¹), in which the capacitances are dual-weighted and the smallest capacitance (C/2ⁿ⁻¹) is provided twice, in which the capacitors (C to C/2ⁿ⁻¹) are connected in each case by one terminal to a first input of a comparator (K) and via a reference switch (SB) to a reference potential (ground), and in which the capacitors (C to C/2ⁿ⁻¹) are connected by their respective other terminal via a further switch (S1 to Sn+1) in each case to an input analog potential (Vx), a reference potential (Vref) or a reference potential (ground), characterized in that the respectively one terminal of the capacitors on the one hand and the first input of the comparator (K) on the other hand are connected in a non-detachable manner in each case to the terminals of a coupling capacitor (Ck), and in that there is connected permanently to a second input of the comparator (K) a further coupling capacitor (Ck1) which is connected to a common potential (ground) and the capacitance of which is essentially determined by the capacitance of the series circuit of the coupling capacitor (Ck) and of the capacitor network (C to C/2ⁿ⁻¹).

2. Analog/digital converter operating on the principle of charge distribution with a capacitor network (C to C/2ⁿ⁻¹), in which the capacitances are dual-weighted and the smallest capacitance (C/2ⁿ⁻¹) is provided twice, in which the capacitors (C to C/2ⁿ⁻¹) are connected in each case by one terminal to a first input of a comparator (K) and via a reference switch (SB) to a reference potential (ground), and in which the capacitors (C to C/²ⁿ⁻¹) are connected by their respectively other terminal via a further switch (S1 to Sn+1) in each case to an input analog potential (Vx), a reference potential (Vref) or a reference potential (ground), characterized in that a coupling capacitor (CK) is connected upstream of the first input of the comparator (K), and a further coupling capacitor (Ck1), connected to the reference potential (ground) via a simulation switch arrangement (SD1 to SDi), is connected upstream of a second input of the comparator (K).

3. Analog/digital converter according to Claim 2, characterized in that the simulation switch arrangement (SD1 to SDi) is designed so that it is able to simulate the entire switch resistance or switching operations of the converter branch using the capacitor network (C to C/2ⁿ⁻¹).

## Revendications

1. Convertisseur analogique/numérique fonctionnant selon le principe de la répartition de charge, comportant un réseau de capacités (C à C/2ⁿ⁻¹), dans lequel les valeurs des capcités sont pondérées en binaire et la plus faible valeur de capacité (C/2ⁿ⁻¹) est prévue en double, et dans lequel les capacités (C à C/2ⁿ⁻¹) sont reliées chacune, par une borne, à une première entrée d'un comparateur (K) et sont placées à un potentiel de référence (Masse) par l'intermédiaire d'un interrupteur de référence (SB), et dans lequel les capacités (C à C/2ⁿ⁻¹) sont reliées, par leur première borne respective, par l'intermédiaire respectivement d'un autre interrupteur (S1 à Sn+1), à un potentiel analogique d'entrée (Vx), à un potentiel de référence (Vref) ou à un potentiel de référence (Masse),
caractérisé par le fait
que la première borne des capacités, d'une part, et la première entrée des comparateurs (K), d'autre part, sont raccordées respectivement de façon inamovible aux bornes d'un condensateur de couplage (Ck), et qu'à une seconde entrée du comparateur (K) est raccordée de façon fixe un autre condensateur de couplage (Ck1), qui est relié à un potentiel commun (Masse) et dont la valeur est déterminée essentiellement par la valeur capacitive du circuit série formé par le condensateur de couplage (Ck) et le réseau de capacités (C à C/2ⁿ⁻¹).

2. Convertisseur analogique/numérique fonctionnant selon le principe de la répartition de charge, comportant un réseau de capacités (C à C/2ⁿ⁻¹), dans lequel les valeurs des capcités sont pondérées en binaire et la plus faible valeur de capacité (C/2ⁿ⁻¹) est prévue en double, et dans lequel les capacités (C à C/2ⁿ⁻ 1) sont reliées chacune, par une borne, à une première entrée d'un comparateur (K) et sont placées à un potentiel de référence (Masse) par l'intermédiaire d'un interrupteur de référence (SB), et dans lequel les capacités (C à C/2ⁿ⁻¹) sont reliées, par leur première borne respective, par l'intermédiaire respectivement d'un autre interrupteur (S1 à Sn+1), à un potentiel analogique d'entrée (Vx), à un potentiel de référence (Vref) ou à un potentiel de référence (Masse),
caractérisé par le fait
qu'un condensateur de couplage (CK) est branché en amont de la première entrée du comparateur (K), et qu'un autre condensateur de couplage (Ck1), qui est relié au potentiel de référence (Masse) par l'intermédiaire d'un dispositif à interrupteurs de simulation (SD1 à SDi), est branché en amont d'une seconde entrée du comparateur (K).

3. Convertisseur analogique/numérique suivant la revendication 2, caractérisé par le fait que le dispositif à interrupteurs de simulation (SD1 à SDi) est agencé de manière à pouvoir simuler la résistance d'ensemble des interrupteurs ou des processus de commutation de la branche du convertisseur possédant le réseau de capacités (C à C/2ⁿ⁻¹)
